# EUROPÄISCHE PATENTANMELDUNG

(11) **EP 3 594 706 A1**
(43) Veröffentlichungstag der Anmeldung: **15.01.2020**
(21) Anmeldenummer: 18183427.6
(22) Anmeldetag: 13.07.2018
(51) Int. Cl.: G01R 33/34, G01R 33/565

(54) **FLEXIBLE LOKALSPULE MIT MARKER UND BILDGEWINNUNGSVERFAHREN**

(71) Anmelder: Siemens Healthcare GmbH, 91052 Erlangen (DE)
(72) Erfinder: Lauer, Lars, 91077 Neunkirchen (DE); Schnell, Wilfried, 91301 Forchheim (DE); Schröter, Steffen, 90763 Fürth (DE)

(57) **Zusammenfassung**

Magnetresonanzuntersuchungen sollen komfortabler und die entsprechende Bildgebung hochwertiger gestaltet werden. Dazu wird eine Lokalspule (1) für ein Magnetresonanzgerät (2) mit einer Leitungseinrichtung (9), welche eine elektrisch leitfähige Struktur aufweist, vorgeschlagen. Die Leitungseinrichtung (9) ist zumindest bereichsweise dehnbar und/oder biegbar oder aber individuell an einen Patienten (3) angepasst. Die Lokalspule weist außerdem eine an der Leitungseinrichtung (9) befestigte Markereinrichtung (6) auf, die ein oder mehrere Markerelemente (8) besitzt, welche ausschließlich die Funktion eines Markierens einer Position der Lokalspule (1) oder eines Teils davon aufweisen.

## Beschreibung

Die vorliegende Erfindung betrifft eine Lokalspule für ein Magnetresonanzgerät mit einer Leitungseinrichtung, welche eine elektrisch leitfähige Struktur aufweist, wobei die Leitungseinrichtung zumindest bereichsweise dehnbar und/oder biegbar ist, oder aber individuell an einen Patienten angepasst ist. Darüber hinaus betrifft die vorliegende Erfindung ein Magnetresonanzgerät mit einer solchen Lokalspule. Ferner bezieht sich die Erfindung auf ein Verfahren zur Bildgewinnung mit einem solchen Magnetresonanzgerät.

In einem Magnetresonanzgerät, auch Magnetresonanztomographiesystem genannt, wird üblicherweise der zu untersuchende Körper eines Untersuchungsobjekts, beispielsweise eines Patienten, eines gesunden Probanden, eines Tiers oder eines Phantoms mit Hilfe eines Hauptmagneten einem relativ hohen Hauptmagnetfeld, beispielsweise von 1,5 oder 3 oder 7 Tesla, ausgesetzt. Zusätzlich werden mit Hilfe einer Gradientenspuleneinheit Gradientenfelder erzeugt. Über eine Hochfrequenzantenneneinheit werden dann mittels geeigneter Antenneneinrichtungen Hochfrequenz-Pulse, beispielsweise Anregungspulse, ausgesendet, was dazu führt, dass die Kernspins bestimmter, durch diese Hochfrequenz-Pulse resonant angeregter Atome um einen definierten Flipwinkel gegenüber den Magnetfeldlinien des Hauptmagnetfelds verkippt werden. Bei der Relaxation des Kernspins werden Hochfrequenz-Signale, sogenannte Magnetresonanz-Signale, abgestrahlt, die mittels geeigneter Hochfrequenz-Antennen empfangen und dann weiterverarbeitet werden. Aus den so akquirierten Rohdaten können schließlich die gewünschten Bilddaten rekonstruiert werden.

Bei den Antenneneinrichtungen handelt es sich typischerweise um Spulen, in denen durch das Magnetresonanz-Signal eine Spannung induziert wird. Diese Empfangsspulen werden idealerweise möglichst nahe an einem Untersuchungsobjekt, insbesondere einem Patienten, angeordnet. Deshalb werden diese auch als Lokalspulen bezeichnet. Die induzierte Spannung wird üblicherweise mittels eines rauscharmen Vorverstärkers verstärkt an die Empfangselektronik weitergeleitet.

Heute gibt es verschiedene Lokalspulentypen, meist für bestimmte anatomische Regionen, wie z.B. Kopf, Knie, Brust, Herz, Prostata, Fußgelenk, Handgelenk und Schulter. Beispielhafte Lokalspulen sind in den Druckschriften US 20150355296 A1, US 8947088 B2, US 9194924 B2, US 20150065852 A1 und US 20150057528 A1 beschrieben. Die Anpassung an eine spezifische Patientenform bzw. Körperkontur ist bei heutigen Lokalspulen in der Regel verbesserungsfähig, weil diese oftmals für eine durchschnittliche Patientenform konstruiert werden. Dies führt insbesondere zu reduzierten Füllfaktoren und/oder erhöhten Verkopplungen und damit zu einem schlechteren Signal-Rausch-Verhältnis.

Die Gewinnung von Magnetresonanzbildern ist in der Regel eine langwierige Prozedur. Während die Aufnahmen gewonnen werden, muss sich der Patient absolut ruhig halten. Anderenfalls werden die Aufnahmen verschwommen.

Die Aufgabe der vorliegenden Erfindung besteht darin, das Aufnahmeverfahren bei der Magnetresonanztomographie für den Patienten angenehmer zu gestalten und eine Möglichkeit zu schaffen, die Bildqualität steigern zu können.

Erfindungsgemäß wird diese Aufgabe gelöst durch eine Lokalspule und ein Verfahren zur Bildgewinnung mit einem Magnetresonanzgerät entsprechend den unabhängigen Ansprüchen. Vorteilhafte Weiterbildungen der Erfindung ergeben sich aus den Unteransprüchen.

Erfindungsgemäß wird demnach bereitgestellt eine Lokalspule für ein Magnetresonanzgerät mit einer Leitungseinrichtung, welche eine elektrisch leitfähige Struktur aufweist, wobei die Leitungseinrichtung zumindest bereichsweise dehnbar und/oder biegbar ist oder aber individuell an einen Patienten angepasst ist. Die Leitungseinrichtung entspricht im Wesentlichen der eigentlichen Spule, in der die hochfrequenten Spannungen induziert werden. Der eigentliche elektrische Leiter wird hier als elektrisch leitfähige Struktur bezeichnet. Dabei handelt es sich etwa um übliche Silber- oder Kupferleiter, ggf. in Litzenform. Diese eigentlichen elektrischen Leiter bzw. diese elektrisch leitfähige Struktur kann mit geeigneten Materialien isoliert sein und damit im Wesentlichen die Leitungseinrichtung bilden. Gegebenenfalls sind auch ein oder mehrere Trägerelemente der Leitungseinrichtung vorhanden, die die elektrisch leitfähige Struktur tragen bzw. in die die elektrisch leitfähigen Strukturen eingearbeitet sind.

In einer Variante ist die Leitungseinrichtung zumindest bereichsweise, vorzugsweise insgesamt dehnbar bzw. biegbar. Die Leitungseinrichtung mit der elektrisch leitfähigen Struktur ist also in sich flexibel und kann so an die jeweiligen Körperkonturen angepasst werden, so dass sie sehr eng am zu untersuchenden Körper anliegt. In der anderen Variante ist vorgesehen, dass die Leitungseinrichtung bzw. die gesamte Lokalspule individuell an den Patienten angepasst ist. Dies hat den Vorteil, dass qualitativ hochwertige Signale von dem jeweiligen Körperteil des Patienten gewonnen werden können. Die Lokalspule liegt nämlich vorzugsweise exakt an dem Körperteil an, von dem die Bilder gewonnen werden müssen. Derartige individuelle Lokalspulen können beispielsweise für solche Fälle hergestellt werden, in denen etwa eine Kontrolluntersuchung alle vier Wochen notwendig ist.

Die Lokalspule besitzt eine an der Leitungseinrichtung befestigte Markereinrichtung, die ein Markerelement aufweist, welches ausschließlich die Funktion eines Markierens einer Position der Lokalspule besitzt. Neben der Leitungseinrichtung besitzt die Lokalspule also eine Markereinrichtung, die fest mit der Leitungseinrichtung verbunden ist, damit diese beiden Komponenten eine feste örtliche Beziehung zueinander haben. Wird die Position der Markereinrichtung festgestellt, so lässt sich damit auch die Position der Leitungseinrichtung bzw. der Lokalspule insgesamt schätzen bzw. gewinnen. Die Markereinrichtung besitzt ein Markerelement, welches nur die Funktion des Markierens besitzt. D.h. das Markerelement dient an der Lokalspule nur dazu, lokalisiert zu werden. Dazu kann das Markerelement unterschiedlichste geometrische Formen sowie unterschiedlichste Oberflächengestaltungen aufweisen. Beispielsweise ist das Markerelement punktförmig bzw. kugelförmig ausgebildet, und sein Zentrum repräsentiert die gesuchte Position der bzw. an der Lokalspule. Gegebenenfalls besitzt das Markerelement aber auch beispielsweise mehrere Arme, die in verschiedene Raumrichtungen ragen, so dass nicht nur die Position, sondern auch die Orientierung der Lokalspule aus den Erfassungssignalen des Markerelements registriert werden können.

Die Markereinrichtung besitzt unter Umständen auch eine Befestigungseinheit, mit der das Markerelement an der Leitungseinrichtung befestigt ist. Im einfachsten Fall, wenn das Markerelement lediglich ein Farbpunkt auf der Leitungseinrichtung ist, kann eine untere Farbschicht als Befestigungseinheit angesehen werden, die eine obere Farbschicht (das eigentliche Markerelement) an der Leitungseinrichtung hält. Bei einer aufwendigeren Konstruktion ist die Befestigungseinheit beispielsweise ein kleiner Fuß oder ein kleines Stäbchen, an dessen einem Ende die Leitungseinrichtung und an dessen anderem Ende das Markerelement befestigt ist. Optional kann das Markerelement auch lösbar bzw. austauschbar an der Leitungseinrichtung befestigt sein.

In einer Ausführungsform weicht das Markerelement in seinem elektromagnetischen Reflektionsgrad oder Absorptionsgrad von der übrigen Lokalspule ab. Dies bedeutet beispielsweise, dass die Lokalspule weiß gefärbt ist, während das Markerelement rot, grün oder andersfarbig ist. Alternativ kann aber auch vorgesehen sein, dass das Markerelement sich beispielsweise im Infrarotbereich von der Lokalspule abhebt.

Entsprechend einer weiteren Ausgestaltung ist vorgesehen, dass die Leitungseinrichtung größtenteils als textiles Gebilde ausgebildet ist. Durch ein derartiges textiles Gebilde lässt sich die Flexibilität der Leitungseinrichtung erreichen. Unter einem textilen Gebilde wird beispielsweise ein Gewebe mit Schuss- und Kettfäden und/oder ein Gewirke und/oder Gestricke und/oder ein Geflecht verstanden. Unter dem textilen Gebilde kann also insbesondere eine ineinander geschlungene Anordnung mehrerer Stränge aus biegsamem Material, insbesondere aus metallischen Drähten und/oder Adern, verstanden werden. Das textile Gebilde kann also beispielsweise ein Drahtgeflecht umfassen.

In einer speziellen Ausführungsform besitzt die Leitungseinrichtung die Form einer Haube, insbesondere für einen menschlichen Kopf. Dies bedeutet, dass die Lokalspule spezifisch dafür verwendet werden kann, dass Aufnahmen des Kopfes des Patienten gewonnen werden. Die Haube sollte so dimensioniert sein, dass sie eng am Kopf des Patienten sitzt. Die haubenförmige Lokalspule mit der Markereinrichtung hat also den Vorteil, dass sie einfach auf den Kopf aufgesetzt werden kann und eine zusätzliche Befestigung eines Markers, z.B. auf der Nase des Patienten, nicht notwendig ist.

In einer alternativen Ausgestaltungsform kann die Leitungseinrichtung die Form eines einseitig oder beidseitig offenen Strumpfs, insbesondere für ein menschliches Bein oder Knie oder für einen menschlichen Fuß oder Ellenbogen, besitzen. Die Lokalspule kann damit auch leicht an anderen Körperteilen als dem Kopf befestigt werden, wie etwa Arme und Beine. Ein derartiger Strumpf lässt sich ohne Weiteres über die Extremitäten eines Patienten ziehen und hält von sich aus an der gewünschten Stelle. Auch bei Bewegungen des jeweiligen Körperteils folgt die Lokalspule wie auch bei der Haubenform unmittelbar dem Körperteil. Auf diese Weise ist stets ein optimaler Empfang der Lokalspule gewährleistet. Durch die Markereinrichtung kann auch stets der Ort der strumpfförmigen Lokalspule exakt verfolgt werden, um beispielsweise das bzw. die Gradientenfelder entsprechend nachzuführen.

Des Weiteren kann die Leitungseinrichtung die Form eines Bands, insbesondere für eine menschliche Hüfte oder Schulter, besitzen. Ein derartiges Band muss nicht in sich geschlossen sein, sondern kann entsprechend einer kleinen Decke gestaltet sein. Durch seine Flexibilität passt sich das Band sehr gut an die jeweilige Körperkontur an.

In einer weiteren Ausgestaltungsform ist vorgesehen, dass die Markereinrichtung körperlich von der Leitungseinrichtung absteht. Dies kann beispielsweise dadurch realisiert werden, dass, wie oben bereits angedeutet wurde, die Markereinrichtung als Befestigungseinheit ein Stäbchen oder dergleichen besitzt, an dessen einem Ende das Markerelement und dessen anderem Ende die Leitungseinrichtung befestigt ist. Eine solche abstehende Markereinrichtung hat den Vorteil, dass das Markerelement der Markereinrichtung leichter optisch erfasst werden kann und nicht durch Teile der Leitungseinrichtung ohne Weiteres verdeckt wird.

Entsprechend einer weiteren Ausgestaltung ist die gesamte Lokalspule durch ein additives Herstellungsverfahren gefertigt. Dabei kann es sich um ein Pulverbettverfahren oder ein Freiraumverfahren handeln. Weit verbreitet sind beispielsweise selektive Laserschmelzverfahren oder Elektronenstrahlschmelzverfahren. Mit einem solchen additiven Herstellungsverfahren lässt sich ein Teil, aber auch die gesamte Lokalspule einschließlich der elektrisch leitfähigen Struktur, herstellen. Insbesondere kann auch eine elektronische Schaltung, die Teil der Lokalspule ist und zur Vorverarbeitung der Signale dient, bei dem additiven Herstellungsverfahren mithergestellt werden. Solche additiven bzw. generativen Herstellungsverfahren können sowohl für die dehnbaren bzw. biegbaren Leitungseinrichtungen, aber auch für starre, individuell an einen Patienten angepasste Leitungseinrichtungen bzw. Lokalspulen verwendet werden. Gerade die individuelle Anpassung der Leitungseinrichtung bzw. Lokalspule kann durch das additive Herstellungsverfahren leicht realisiert werden. Wirtschaftlich kann dies insbesondere in solchen Fällen von Bedeutung sein, dass in kürzeren Zeitabständen zur Überwachung immer wieder der gleiche Patient untersucht werden muss. Mit derart individuell angepassten Spulen lassen sich eine hohe Bildqualität und eine hohe Reproduzierbarkeit gewährleisten.

In einer Ausführungsform weist die Leitungseinrichtung ein dielektrisches Substrat auf, auf das die elektrisch leitfähige Struktur aufgedruckt ist. Dieses dielektrische Substrat dient also als isolierender Träger der elektrisch leitfähigen Struktur. Durch das Aufdrucken können sehr dünne Leiterbahnen erzielt werden, welche insbesondere vorteilhaft hinsichtlich der Biegbarkeit und Dehnbarkeit der Leitungseinrichtung sind. Außerdem können durch das Aufdrucken sehr geringe Herstellungskosten erzielt werden.

Erfindungsgemäß kann somit auch ein Magnetresonanzgerät mit einer der oben genannten Lokalspulen hergestellt werden. Insbesondere kann die Lokalspule gemäß den oben genannten Aspekten variiert sein. Das Magnetresonanzgerät besitzt darüber hinaus eine Sensoreinrichtung zum automatischen Verfolgen des Markerelements auf der Lokalspule. Beispielsweise besitzt die Sensoreinrichtung eine oder mehrere Kameras, mit denen die genaue Position des Markerelements im Raum ermittelt werden kann. Speziell ist vorgesehen, dass die Sensoreinrichtung, gegebenenfalls auch auf Infrarotbasis, das Markerelement automatisch verfolgt, indem beispielsweise ständig Bilder von dem Markerelement generiert werden. Mit diesen Bildern lässt sich dann beispielsweise mehrfach pro Sekunde die genaue Position und/oder Orientierung des Markerelements und damit auch der Lokalspule ermitteln. Die Sensoreinrichtung kann hierzu beispielsweise an einem Gehäuse des Magnetresonanzgeräts und insbesondere in einem Untersuchungskanal des Magnetresonanzgeräts angeordnet sein. Gegebenenfalls kann ein Teil der Sensoreinrichtung (z.B. eine oder mehrere Kameras) auch an einem Patiententisch des Magnetresonanzgeräts befestigt sein. Die von der Sensoreinrichtung gewonnenen Signale bzw. Bilder werden z.B. von einer Steuereinrichtung des Magnetresonanzgeräts weiterverarbeitet.

Wie soeben angedeutet wurde, kann das Magnetresonanzgerät auch einen Patiententisch aufweisen, wobei die Lokalspule gegenüber dem Patiententisch frei beweglich ist. Der Patient setzt die Lokalspule in Form einer Haube beispielsweise auf oder streift sie in Form eines Strumpfes über und legt sich auf den Patiententisch. Dabei kann die Lokalspule kabelgebunden mit dem übrigen Magnetresonanzgerät verbunden sein. Die Lokalspule ist dann im Rahmen des verwendeten Kabels gegenüber dem Patiententisch frei beweglich. Gegebenenfalls wird das Kabel auch lösbar an dem Patiententisch befestigt, was speziell während einer Untersuchung vorteilhaft ist. Alternativ ist die Lokalspule drahtlos mit dem übrigen Magnetresonanzgerät verbunden. Die von der Lokalspule aufgenommenen Signale werden dann entsprechend drahtlos beispielsweise an die Steuereinrichtung des Magnetresonanzgeräts übermittelt. In diesem Fall besteht keinerlei Behinderung durch ein sonst übliches Kabel.

Erfindungsgemäß wird die oben genannte Aufgabe auch gelöst durch ein Verfahren zur Bildgewinnung mit einem Magnetresonanzgerät, wie es soeben beschrieben wurde, einschließlich der Schritte:
a) Anbringen der Lokalspule an einem Körperteil eines Patienten derart, dass die Lokalspule an einer Kontur des Körperteils passend anliegt,
b) Verfolgen des Markerelements mit der Sensoreinrichtung zum fortlaufenden Gewinnen von jeweiligen Positionen der Lokalspule und
c) Erzeugen einer Magnetresonanzabbildung in Abhängigkeit von den jeweiligen Positionen der Lokalspule.

Die Lokalspule einschließlich des Markerelements, das an ihr befestigt ist, wird also an das zu untersuchende Körperteil angeschmiegt, so dass eine hohe Signalqualität erreicht wird. Um die negativen Auswirkungen von Bewegungen des Patienten bzw. des Körperteils zu reduzieren bzw. zu minimieren, wird das Markerelement ständig verfolgt, und seine Position wird ständig ermittelt. Aus dieser Position des Markerelements lässt sich auf die Position der Lokalspule schließen, und diese Position der Lokalspule lässt sich wiederum dazu benutzen, die Erzeugung der Magnetresonanzabbildung zu steuern. Insbesondere können die Parameter des Magnetresonanzgeräts in Abhängigkeit von der jeweils aktuellen Position der Lokalspule eingestellt werden. Auf diese Weise können Bewegungen des Körperteils bzw. des Patienten kompensiert werden, so dass sich sehr scharfe Magnetresonanzabbildungen gewinnen lassen.

In einer spezifischen Ausgestaltung ist vorgesehen, dass die Gradientenachsen des Magnetresonanzgeräts in Abhängigkeit von den jeweiligen Positionen der Lokalspule eingestellt werden. Gegebenenfalls besitzt das Magnetresonanzgerät auch mehrere Lokalspulen, und die Gradientenachsen werden in Abhängigkeit von sämtlichen Positionen der Lokalspulen eingestellt. Dazu ist die Sensoreinrichtung vorzugsweise in der Lage, unterschiedliche Markerelemente der Lokalspulen voneinander zu unterscheiden und deren Positionen individuell zu erkennen.

Die Sensoreinrichtung ist auf das bzw. die Markerelemente abgestimmt. Im Falle optischer Erfassung ist das Markerelement (stellvertretend auch für eine Vielzahl von Markerelementen) optisch charakteristisch ausgebildet. Die Sensoreinrichtung kann aber auch Magnetfeldsensoren oder Ultraschallsensoren aufweisen, um entsprechende Markerelemente zu detektieren. Gegebenenfalls besitzt ein Markerelement ein RFID-Tag, das elektromagnetisch von der Sensoreinrichtung erfasst bzw. ausgelesen wird. Auch beliebige andere Positionserfassungssysteme sind für die Kombination von Markerelement und Sensoreinrichtung denkbar.

Des Weiteren kann das erfindungsgemäße Verfahren dahingehend ausgestaltet sein, dass das Anbringen der Lokalspule an dem Körperteil beinhaltet, dass die Lokalspule zunächst durch ein additives Herstellungsverfahren individuell für einen Patienten hergestellt wird und anschließend für die Bildgewinnung an diesen angelegt wird. Es wird also zu Beginn die Lokalspule spezifisch für den Patienten additiv gefertigt, wobei die patientenspezifischen Konturen des jeweiligen Körperteils berücksichtigt werden können. Eine derart individuell gefertigte Lokalspule liegt optimal an dem Patienten an. Bei diesem additiven Herstellungsverfahren kann auch eine Vorverarbeitungselektronik der Lokalspule mithergestellt werden. Dies bedeutet, dass die Lokalspule einstückig mit der Vorverarbeitungselektronik, der Leitungseinrichtung und der Markereinrichtung hergestellt wird, wodurch die Herstellungskosten deutlich reduziert werden können.

Ferner kann vorgesehen sein, dass die Lokalspule eine Vielzahl an fest mit der Leitungseinrichtung verbundenen Markerelementen besitzt, eine räumliche Gestalt der Lokalspule mit der Sensoreinrichtung auf der Basis der vielen Markerelemente gewonnen wird und anhand dieser räumlichen Gestalt das Magnetresonanzgerät gesteuert wird. Handelt es sich also beispielsweise um eine flexible bzw. bieg- und/oder dehnbare Lokalspule, so ändert sich deren Gestalt, wenn sie an das zu untersuchende Körperteil appliziert wird.

Um für eine verbesserte Datenverarbeitung die aktuelle Gestalt der Lokalspule automatisch zu ermitteln, kann eine Vielzahl an Markerelementen, die gleichmäßig über die Lokalspule verteilt angeordnet sind (gegebenenfalls matrixförmig), durch die Sensoreinrichtung in ihrer jeweiligen Position erfasst werden. Je mehr Markerelemente die Lokalspule besitzt, desto exakter kann die räumliche Gestalt der Lokalspule ermittelt werden. Auch bei einer additiv gefertigten individuellen Lokalspule kann es vorteilhaft sein, wenn diese verteilt über ihre Oberfläche mehrere Markerelemente besitzt. In diesem Fall kann die exakte Gestalt der individuell gefertigten Lokalspule automatisch von der Sensoreinrichtung erfasst werden. In jedem Fall kann so die exakte räumliche Gestalt der Lokalspule zur Verbesserung der Bildqualität beitragen, wobei die jeweilige räumliche Gestalt automatisch gewonnen wird.

Die vorliegende Erfindung wird nun anhand der beigefügten Zeichnungen näher erläutert, in denen zeigen:
- FIG 1: eine Lokalspule in Form eines Strumpfes mit Markern für ein Magnetresonanzgerät und
- FIG 2: ein Blockdiagramm eines erfindungsgemäßen Verfahrens.

Die nachfolgend näher geschilderten Ausführungsbeispiele stellen bevorzugte Ausführungsformen der vorliegenden Erfindung dar. Sie sind jedoch nicht einschränkend zu sehen.

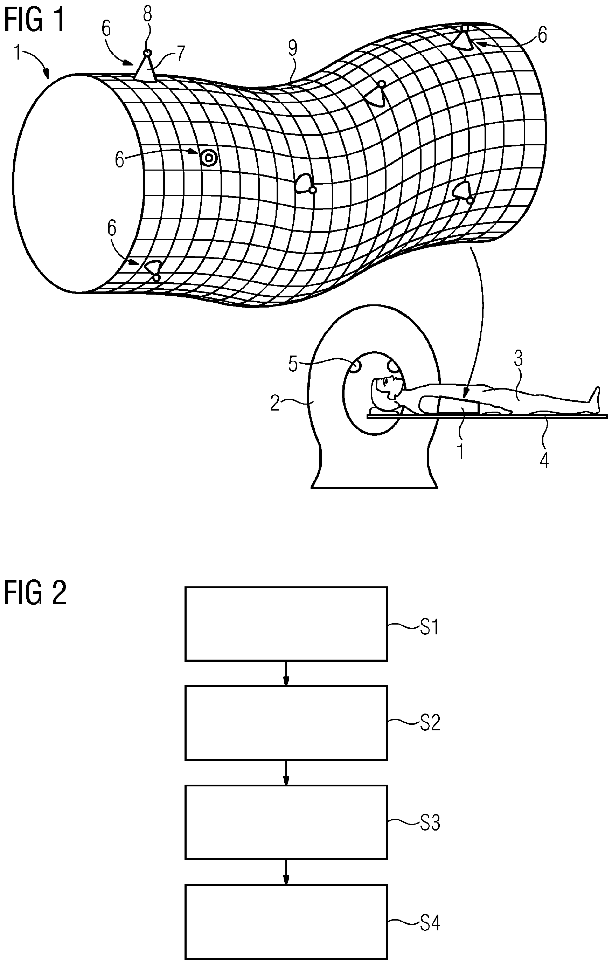

FIG 1 zeigt eine Lokalspule 1 für ein Magnetresonanzgerät 2. Die Lokalspule 1 ist hier strumpfartig ausgebildet und kann beispielsweise über den Ellenbogen eines Patienten 3 gezogen werden. Damit ist es beispielsweise möglich, sehr exakte Aufnahmen von der Ellenbogenregion des Patienten 3 zu gewinnen. Die strumpfförmige Lokalspule 1 ist vorzugsweise biegbar und/oder dehnbar und passt sich somit direkt an die Kontur des Arms bzw. Ellenbogens des Patienten 3 an. Außerdem macht sie jede Bewegung mit, die der Patient 3 mit seinem Arm bzw. Ellenbogen macht. Somit wird die Signalerfassung nicht dadurch gestört, dass die Lokalspule mehr oder weniger weit von dem zu erfassenden Körperteil entfernt ist.

Um mit dem Magnetresonanzgerät 2 scharfe Bilder gewinnen zu können, ist es notwendig, dass sich das zu untersuchende Körperteil über die mehrminütige Prozedur in Ruhe befindet. Dies ist in der Regel für den Patienten 3 unkomfortabel, da stets mit zumindest kleinen Bewegungen zu rechnen ist. Aus diesem Grund sieht die vorliegende Erfindung eine am Körper tragbare Lokalspule 1 vor, die gegenüber dem Patiententisch 4 frei beweglich sein kann und deren Position und gegebenenfalls auch Orientierung durch das Magnetresonanzgerät 2 ständig während einer Aufnahme verfolgbar sind. Die jeweils gewonnenen Positions- und/oder Orientierungsdaten können für die Steuerung des Magnetresonanzgeräts 2 verwendet werden. Insbesondere können sie dazu herangezogen werden, die Gradientenfelder zu beeinflussen.

Die in FIG 1 dargestellte Strumpfform der Lokalspule 1 ist lediglich exemplarisch. Die Lokalspule 1 kann auch beispielsweise eine Haubenform besitzen, so dass sie vom Patienten 3 aufgesetzt werden kann, um Bilder vom Kopf gewinnen zu können. Auch kann die Lokalspule band- oder deckenförmig ausgebildet sein, um beispielsweise eine Hüftregion oder eine Schulterregion des Patienten 3 zu untersuchen. Vorzugsweise ist die Lokalspule 1 also vom Patienten 3 tragbar und hält selbständig an ihm. Gegebenenfalls liegt sie wie eine Decke auch nur auf dem Patienten auf und schmiegt sich diesem an.

Die Lokalspule 1 ist vorzugsweise aus einem textilen Gebilde gefertigt, das eine entsprechende Flexibilität ähnlich einem Strumpf oder eine Mütze gewährleistet. Alternativ kann die Lokalspule 1 aber auch in sich fest sein, aber sie ist ebenfalls nicht mit dem Patiententisch 4 fest verbunden oder mit dem übrigen Magnetresonanzgerät 2. Dies bedeutet, dass die Position bzw. Orientierung der Lokalspule von vornherein nicht bekannt ist und sie darüber hinaus etwaige Bewegungen des Patienten 3 mitmacht.

Die vom Patienten 3 gemachten Bewegungen des zu untersuchenden Körperteils sind von der Bildgebung des Magnetresonanzgeräts 2 zu kompensieren. Dazu verfolgt eine Sensoreinrichtung 5 des Magnetresonanzgeräts 2 ständig die Position bzw. Orientierung der Lokalspule 1. Um ein solches Verfolgen zu ermöglichen, besitzt die Lokalspule 1 einen oder mehrere Markereinrichtungen 6 (kurz: Marker) an ihrer nach außen gerichteten Oberfläche. Die Marker 6 sind also an derjenigen Seite der Lokalspule 1 angeordnet, die vom Patienten wegweist. Auf diese Weise sind sie von der Sensoreinrichtung 5 erfassbar, wenn der Patient 3 die Lokalspule 1 trägt.

Ein Marker 6 besitzt beispielsweise eine Befestigungseinheit 7 und ein Markerelement 8. Die Lokalspule 1 ihrerseits besitzt eine Leitungseinrichtung 9, welche eine elektrisch leitfähige Struktur aufweist. In Beispiel von FIG 1 ist die Leitungseinrichtung 9 gewebeartig aufgebaut, wodurch eine gewisse Flexibilität gegeben ist. Neben der elektrisch leitfähigen Struktur kann die Leitungseinrichtung 9 auch eine in FIG 1 nicht dargestellte Trägerstruktur aufweisen. Insbesondere kann es sich um eine dielektrische Folie handeln, auf die die elektrisch leitfähige Struktur aufgedruckt ist. Ferner kann die gesamte Lokalspule 1 durch ein 3D-Druckverfahren bzw. ein additives Herstellungsverfahren hergestellt sein.

In dem Beispiel von FIG 1 verbindet die Befestigungseinheit 7 das Markerelement 8 eines Markers 6 mit der Leitungseinrichtung 9. Der Marker 6 ist damit auf der Leitungseinrichtung 9 bzw. der Lokalspule 1 fixiert. Gleiches gilt für alle anderen Marker 6, falls solche vorgesehen sind.

Auch wenn die Markerelemente 8 in FIG 1 kugelförmig dargestellt sind, können sie komplexe dreidimensionale Gebilde, z.B. mehrarmige Gebilde, sein. Im letzteren Fall lässt sich auch die Orientierung der Leitungseinrichtung 9 bzw. der Lokalspule 1 anhand der Marker 6 (leichter) erkennen.

Bei den Befestigungseinheiten 7 kann es sich um Füße, Stäbe und dergleichen handeln. Gegebenenfalls ist die Befestigungseinheit 7 jedoch auch nur eine Klebstoffschicht oder eine untere Lackschicht eines lediglich aus einem Lacktropfen gebildeten Markers 6.

Die Markerelemente 8 können eine spezielle Farbe besitzen, damit sie von der Sensoreinrichtung 5 gut vor der Leitungseinrichtung erfasst werden können. Gegebenenfalls sind sie speziell durch Infrarotsensoren erkennbar. Optional besitzen die Markerelemente auch ihre eigene Elektronik, wie etwa RFID-Tags.

Die Lokalspule 1 kann durch ein additives Herstellungsverfahren gefertigt sein. Dabei muss sie nicht flexibel bzw. dehn- und/oder biegbar sein. Vielmehr kann sie auch starr sein. In diesem Fall ist sie jedoch individuell an den Patienten 3 bzw. an die zu untersuchende Körperkontur individuell angepasst.

Eine Lokalspule 1 kann einen einzigen Marker 6 aufweisen. Ein solcher einziger Marker 6 kann genügen, um die Position und Ausrichtung der Lokalspule 1 zumindest grob zu bestimmen bzw. zu schätzen und kontinuierlich zu verfolgen. In einer weiteren Ausführungsform kann jedoch vorgesehen sein, dass die Lokalspule mehrere Marker 6 aufweist, die gegebenenfalls auf der Oberfläche der Lokalspule 1 gleich verteilt angeordnet sind. Die Anzahl kann beispielsweise von zwei bis einige hundert reichen. Im Falle einer sehr großen Anzahl der Marker 6 auf der Lokalspule 1 kann deren dreidimensionale Gestalt direkt von der Sensoreinrichtung 5 des Magnetresonanzgeräts 2 ermittelt werden. Wenn also beispielsweise der Patient eine manschettenartige bzw. strumpfartige Lokalspule 1 um den Ellenbogen trägt und diesen während der Untersuchung abwinkelt, kann dies von der Sensoreinrichtung 5 aufgrund der zahlreichen Marker 6 erkannt werden. Die Steuerung der Magnetfelder einschließlich der Bildverarbeitung kann hierdurch entsprechend angepasst werden.

Auch individuell angepasste, gegebenenfalls mit einem additiven Herstellungsverfahren hergestellte Lokalspulen können zahlreiche Marker 6 aufweisen. In diesem Fall kann dann die Sensoreinrichtung 5 auch die individuelle Gestalt derart fester Lokalspulen 1 automatisch ermitteln, ohne dass der Radiologe entsprechende Geometriedaten von der Lokalspule 1 in die Steuerung des Magnetresonanzgeräts 2 eingeben müsste. Das Magnetresonanzgerät 2 kann somit den Typ und die genaue Gestalt der Lokalspule 1 automatisch erkennen.

FIG 2 gibt einen Verfahrensablauf für eine Bildgewinnung mit einem Magnetresonanzgerät 2 wieder, wobei die oben beschriebene Lokalspule 1 benutzt wird. In einem ersten Schritt S1, der nicht immer den Anwender selbst betrifft und daher als optional anzusehen ist, wird die Lokalspule 1 gefertigt. Dies kann durch konventionelle Methoden, aber auch durch additives Herstellen erfolgen. Daraus kann eine flexible oder individuell angepasste, vom Patienten tragbare Lokalspule 1 resultieren.

In einem zweiten Schritt S2 erfolgt ein Anlegen der Lokalspule 1 an das zu untersuchende Objekt, z.B. das Körperteil eines Patienten. Aufgrund der Dehnbarkeit bzw. Biegbarkeit der Lokalspule in dem einen Fall schmiegt sich die Lokalspule selbst an die Körperkontur des Patienten an, da sie entsprechend elastisch ist. Für den anderen Fall, dass sie fest, aber individuell an die Körperkontur eines Patienten angepasst wurde, wird sie so an dem entsprechenden Körperteil platziert, dass sie dort eng anliegt.

In einem dritten Schritt S3 erfolgt die Messung bzw. Bildaufnahme durch das Magnetresonanzgerät. Gleichzeitig wird die Lokalspule 1 verfolgt. Dies bedeutet, dass die Position und gegebenenfalls Orientierung der Lokalspule 1 während der MRT-Untersuchung ständig neu ermittelt wird (Tracking). Auf diese Weise ist es möglich, die Bewegungen des Patienten bzw. des entsprechenden Körperteils genau zu erfassen und für die Bilderzeugung zu berücksichtigen. Letzteres findet in einem vierten Schritt S4 statt. Dabei werden die Positions- bzw. Orientierungsdaten der Lokalspule 1 für die Steuerung des Magnetresonanzgeräts 2 bzw. die Bildgewinnung verwendet. Gegebenenfalls fließen dabei die Positions- und Orientierungsdaten von zahlreichen Markern 6 ein, welche unter Umständen auch die aktuelle räumliche Gestalt der Lokalspule 1 wiederspiegeln.

Wie oben dargestellt wurde, können mit der erfindungsgemäßen Technologie somit (flexible) Gelenkspulen, die der Patient vor der Untersuchung beispielsweise wie einen Strumpf über das Knie, den Ellenbogen etc. zieht oder als Band um ein Gelenk wickelt, hergestellt werden. Die Patienten haben also nicht nur den Komfort, ihre Gliedmaßen bewegen zu können, sondern die Marker auf der Lokalspule ermöglichen es sogar, diese Bewegungen zu verfolgen und bei der Bildgewinnung entsprechende Kompensationen vorzunehmen. Es wird also eine flexible bzw. individuell angepasste Lokalspule mit einem Bewegungsverfolgungssystem kombiniert. Es bewegt sich somit die neuartige Lokalspule selbst mit dem zu untersuchenden Objekt und nicht das Objekt in einer fixen Lokalspule. Die Bewegungskorrektur kann durch das Tracking eines oder mehrerer auf der Lokalspule fest aufgedruckten bzw. angebrachten Marker erfolgen. Der bzw. die Marker können so beispielsweise in direktem Sichtkontakt optisch ungehindert verfolgt werden.

Die erfindungsgemäße Technologie lässt sich nicht nur auf neurologische Körperteile wie Kopf und Rückenmark, sondern auch auf muskuloskelettale Körperteile, wie etwa Knie, Schulter und dergleichen, anwenden.

## Patentansprüche

1. Lokalspule (1) für ein Magnetresonanzgerät (2) mit
- einer Leitungseinrichtung (9), welche eine elektrisch leitfähig Struktur aufweist, wobei
- die Leitungseinrichtung (9) zumindest bereichsweise dehnbar und/oder biegbar ist, oder aber individuell an einen Patienten (3) angepasst ist,
**gekennzeichnet durch**
- eine an der Leitungseinrichtung (9) befestigte Markereinrichtung (6), die ein oder mehrere Markerelemente (8) aufweist, welche ausschließlich die Funktion eines Markierens einer Position der Lokalspule (1) oder eines Teils davon besitzen.

2. Lokalspule nach Anspruch 1, wobei jedes Markerelement (8) in seinem elektromagnetischen Reflexionsgrad oder Absorptionsgrad von der übrigen Lokalspule (1) abweicht.

3. Lokalspule nach Anspruch 1 oder 2, wobei die Leitungseinrichtung (9) größtenteils als textiles Gebilde ausgebildet ist.

4. Lokalspule nach einem der vorhergehenden Ansprüche, wobei die Leitungseinrichtung die Form einer Haube insbesondere für einen menschlichen Kopf besitzt.

5. Lokalspule nach einem der Ansprüche 1 bis 3, wobei die Leitungseinrichtung (9) die Form eines einseitig oder beidseitig offenen Strumpfes insbesondere für ein menschliches Bein oder Knie oder für einen menschlichen Fuß oder Ellenbogen besitzt.

6. Lokalspule nach einem der Ansprüche 1 bis 3, wobei die Leitungseinrichtung (9) die Form eines Bands insbesondere für eine menschliche Hüfte oder Schulter besitzt.

7. Lokalspule nach einem der vorhergehenden Ansprüche, wobei die Markereinrichtung (6) körperlich von der Leitungseinrichtung (9) absteht.

8. Lokalspule nach einem der vorhergehenden Ansprüche, wobei die gesamte Lokalspule (1) durch ein additives Herstellungsverfahren hergestellt ist.

9. Lokalspule nach einem der vorhergehenden Ansprüche, wobei die Leitungseinrichtung (9) ein dielektrisches Substrat aufweist, auf das die elektrisch leitfähige Struktur aufgedruckt ist.

10. Magnetresonanzgerät (2) mit einer Lokalspule (1) nach einem der vorhergehenden Ansprüche und mit einer Sensoreinrichtung (5) zum automatischen Verfolgen des oder der Markerelemente (8) auf der Lokalspule (1).

11. Magnetresonanzgerät nach Anspruch 10 mit einem Patiententisch (4), wobei die Lokalspule (1) gegenüber dem Patiententisch (4) frei beweglich ist.

12. Verfahren zur Bildgewinnung mit einem Magnetresonanzgerät (2) nach Anspruch 10 oder 11, mit den Schritten:
a) Anbringen der Lokalspule (1) an einem Körperteil eines Patienten (3) derart, dass die Lokalspule (1) an eine Kontur des Körperteils passend anliegt,
b) Verfolgen des oder der Markerelemente (8) mit der Sensoreinrichtung (5) zum fortlaufenden Gewinnen von jeweiligen Positionen der Lokalspule (1) oder von Teilen davon und
c) Erzeugen einer Magnetresonanzabbildung in Abhängigkeit von den jeweiligen Positionen der Lokalspule (1) oder von Teilen davon.

13. Verfahren nach Anspruch 12, wobei Gradientenachsen des Magnetresonanzgeräts in Abhängigkeit von den jeweiligen Positionen der Lokalspule (1) eingestellt werden.

14. Verfahren nach Anspruch 12 oder 13, wobei das Anbringen beinhaltet, dass die Lokalspule (1) zunächst durch ein additives Herstellungsverfahren individuell für einen Patienten (3) hergestellt wird und anschließend für die Bildgewinnung an diesen angelegt wird.

15. Verfahren nach einem der Ansprüche 12 bis 14, wobei die Lokalspule (1) eine Vielzahl an fest mit der Leitungseinrichtung (9) verbundenen Markerelementen (8) besitzt, eine räumliche Gestalt der Lokalspule (1) mit der Sensoreinrichtung (5) gewonnen wird und anhand dieser räumlichen Gestalt das Magnetresonanzgerät (2) gesteuert wird.

## Geänderte Patentansprüche

### Geänderte Patentansprüche gemäss Regel 137(2) EPÜ.

1. Lokalspule (1) für ein Magnetresonanzgerät (2) mit
- einer Leitungseinrichtung (9), welche eine elektrisch leitfähig Struktur aufweist,
- einer an der Leitungseinrichtung (9) befestigten Markereinrichtung (6), die ein oder mehrere Markerelemente (8) aufweist, welche ausschließlich die Funktion eines Markierens einer Position der Lokalspule (1) oder eines Teils davon besitzen,
**dadurch gekennzeichnet, dass**
- die gesamte Lokalspule (1) durch ein additives Herstellungsverfahren hergestellt ist und
- die Leitungseinrichtung (9) individuell an einen Patienten (3) angepasst ist.

2. Lokalspule nach Anspruch 1, wobei jedes Markerelement (8) in seinem elektromagnetischen Reflexionsgrad oder Absorptionsgrad von der übrigen Lokalspule (1) abweicht.

3. Lokalspule nach Anspruch 1 oder 2, wobei die Leitungseinrichtung (9) größtenteils als textiles Gebilde ausgebildet ist.

4. Lokalspule nach einem der vorhergehenden Ansprüche, wobei die Leitungseinrichtung die Form einer Haube insbesondere für einen menschlichen Kopf besitzt.

5. Lokalspule nach einem der Ansprüche 1 bis 3, wobei die Leitungseinrichtung (9) die Form eines einseitig oder beidseitig offenen Strumpfes insbesondere für ein menschliches Bein oder Knie oder für einen menschlichen Fuß oder Ellenbogen besitzt.

6. Lokalspule nach einem der Ansprüche 1 bis 3, wobei die Leitungseinrichtung (9) die Form eines Bands insbesondere für eine menschliche Hüfte oder Schulter besitzt.

7. Lokalspule nach einem der vorhergehenden Ansprüche, wobei die Markereinrichtung (6) körperlich von der Leitungseinrichtung (9) absteht.

8. Lokalspule nach einem der vorhergehenden Ansprüche, wobei die Leitungseinrichtung (9) ein dielektrisches Substrat aufweist, auf das die elektrisch leitfähige Struktur aufgedruckt ist.

9. Magnetresonanzgerät (2) mit einer Lokalspule (1) nach einem der vorhergehenden Ansprüche und mit einer Sensoreinrichtung (5) zum automatischen Verfolgen des oder der Markerelemente (8) auf der Lokalspule (1).

10. Magnetresonanzgerät nach Anspruch 9 mit einem Patiententisch (4), wobei die Lokalspule (1) gegenüber dem Patiententisch (4) frei beweglich ist.

11. Verfahren zur Bildgewinnung mit einem Magnetresonanzgerät (2) nach Anspruch 10 oder 11, mit den Schritten:
a) Anbringen der Lokalspule (1) an einem Körperteil eines Patienten (3) derart, dass die Lokalspule (1) an eine Kontur des Körperteils passend anliegt,
b) Verfolgen des oder der Markerelemente (8) mit der Sensoreinrichtung (5) zum fortlaufenden Gewinnen von jeweiligen Positionen der Lokalspule (1) oder von Teilen davon und
c) Erzeugen einer Magnetresonanzabbildung in Abhängigkeit von den jeweiligen Positionen der Lokalspule (1) oder von Teilen davon,
**dadurch gekennzeichnet, dass**
das Anbringen beinhaltet, dass die Lokalspule (1) zunächst durch ein additives Herstellungsverfahren individuell für einen Patienten (3) hergestellt wird und anschließend für die Bildgewinnung an diesen angelegt wird.

12. Verfahren nach Anspruch 11, wobei Gradientenachsen des Magnetresonanzgeräts in Abhängigkeit von den jeweiligen Positionen der Lokalspule (1) eingestellt werden.

13. Verfahren nach einem der Ansprüche 11 bis 12, wobei die Lokalspule (1) eine Vielzahl an fest mit der Leitungseinrichtung (9) verbundenen Markerelementen (8) besitzt, eine räumliche Gestalt der Lokalspule (1) mit der Sensoreinrichtung (5) gewonnen wird und anhand dieser räumlichen Gestalt das Magnetresonanzgerät (2) gesteuert wird.
